# EUROPEAN PATENT APPLICATION

(11) **EP 1 788 855 A1**
(43) Date of publication of application: **23.05.2007**
(21) Application number: 05300946.0
(22) Date of filing: 18.11.2005
(51) Int. Cl.: H05K 7/14

(54) **Connection arrangement for a front access shelf used in an electronic equipment**

(71) Applicant: Alcatel Lucent, 75008 Paris (FR)
(72) Inventor: Hernandez Gamazo, José Miguel, 28005, Madrid (ES)
(74) Representative: Chaffraix, Sylvain

(57) **Abstract**

A connection arrangement for a shelf (1) for receiving replaceable electronic cards at the front side (21) thereof, the shelf further comprising a back-plane (3) for providing access to internal electrical connections inside the shelf (1) located at the rear side thereof (31). A further plane of access (9, 10) for connection of input and/or output signals to and from the shelf (1) respectively is provided such that said further plane of access (9, 10) is in a position which is different from the front side (21) and the rear side (31) of the shelf (1).

## Description

The present invention relates to a connection arrangement for a front access shelf used in an electronic equipment. In particular, the present invention provides a solution according to which separate connection planes are provided for input/output signals and the internal signals. This arrangement is provided in such a manner that the front plane of the equipment is maintained easily accessible for performing the tasks of insertion and extraction of replaceable electronic cards.

### BACKGROUND OF THE INVENTION

Many types of electronic equipment are physically constructed in the form of structures generally known as shelves. The electronic circuitry is then installed in these shelves in form of replaceable cards which are inserted and fixed in place.

In a typical shelf, connections must be provided between the shelf and other external equipment or other shelves for inputting and outputting electronic signals; also internal connections are needed for interconnecting certain parts of the circuitry installed inside the shelf itself.

In the known front access equipment with replaceable cards, both the input/output (hereinafter referred to as I/O) and the internal connections are in the same or in parallel planes. The known arrangement fall; in general, within three basic configurations as described below.

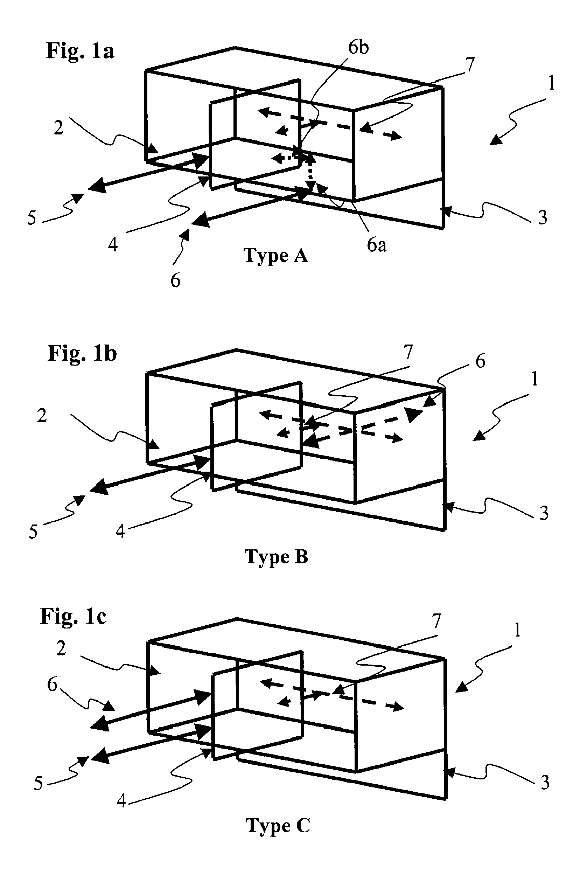

Figures 1 a, 1b and 1 c show simplified schematic representations of the above three configurations in which, for the sake of simplicity, like elements are given like reference numerals.

In figure 1 a, a first known type of connection arrangement for a shelf is shown, hereinafter referred to as connection type "A", wherein a shelf 1 is represented having a front-plane 2 and a back-plane 3. A replaceable electronic card 4 is also shown in a position suitable for insertion inside the shelf 1. As shown, the card 4 is inserted to or extracted from the front plane 2 of the shelf, this is shown by means of arrow 5. In this first configuration, I/O signal connection is provided from external equipment through access from the front-plane 2 - this is shown by means of arrow 6 - and the I/O signals are then routed towards the various points of the circuitry inside the shelf 1 through the back-plane 3 - this is shown by means of arrows 6a and 6b. The internal connections between components inside the shelf 1 are also routed through the back-plane 3 as shown by the set of arrows 7.

In figure 1b, a second known type of connection arrangement for a shelf is shown, hereinafter referred to as connection type "B", wherein a shelf 1 is represented having a front-plane 2 and a back-plane 3. A replaceable electronic card 4 is also shown in a position suitable for insertion inside the shelf 1. As shown, the card 4 is inserted to or extracted from the front plane 2 of the shelf, this is shown by means of arrow 5. In this second configuration, I/O signal connection is provided from external equipment through access from the rear side of the shelf to the back-plane 3 - this is shown by means of arrow 6 - and these I/O signals are also routed towards the various points of the circuitry inside the shelf 1 through the same back-plane 3. The internal connections between components inside the shelf 1 are also routed through the back-plane 3 as shown by the set of arrows 7.

In figure 1c, a third known type of connection arrangement for a shelf is shown, hereinafter referred to as connection type "C", wherein a shelf 1 is represented having a front-plane 2 and a back-plane 3. A replaceable electronic card 4 is also shown in a position suitable for insertion inside the shelf 1. As shown, the card 4 is inserted to or extracted from the front plane 2 of the shelf, this is shown by means of arrow 5. In this third configuration, I/O signal connection is provided from external equipment through access from the front side of the shelf to the front-plane 2 - this is shown by means of arrow 6 - and the I/O signals are also routed towards the various points of the circuitry inside the shelf 1 through the front-plane 2, by means of front plates of boards installed at the front side of the shelf (not shown). The internal connections between components inside the shelf 1 are also routed through the back-plane 3 as shown by the set of arrows 7.

The above three configurations may be summarized in the table below:

| Type | Cards Access insertion/extraction | Internal signals interconnection | I/O signals location | I/O Access |
|---|---|---|---|---|
| A | Front-plane | Back-plane | Back-plane | Front |
| B | Front-plane | Back-plane | Back-plane | Rear |
| C | Front-plane | Back-plane | Front-plane cards | Front |

The above known arrangements suffer from the following drawbacks:

A configuration according to type A would require a relatively large number of layers in the back-plane in order to route both, the internal signals and the I/O signals. Furthermore, it requires a complete set of connectors in the card and in the back-plane in order to provide the necessary connections. These requirements give rise to an increase in costs, thus making the arrangement relatively expensive.

Moreover, once the shelf is defined to route a maximum number of I/O signals through the back-plane, further increase in terms of the number of I/O signals per card would not be possible unless the back-plane is re-designed, thus limiting the possibility of evolution or improvements in this respect.

A configuration according to type B would provide a less expensive solution as compared to the type A configuration, however it would require rear access to the shelf which in turn would demand the availability of empty spaces, both in the front side and the rear side of the shelf.

Furthermore, this solution has similar limitations as those discussed in relation to type A, concerning the inability to achieve evolution in the system in order to improve its density of I/O signals per card and slot.

A configuration according to type C, would provide a less expensive solution as compared to type A, however it would require a more complicated connection arrangement to route the I/O signals through plates of board at the front side. In particular, when the number of the I/O signals per card is high in every consecutive slot, the routing of the connection arrangement becomes complicated which would in turn hinder the insertion and extraction capability at the front side of the shelf.

Furthermore, this configuration may require a minimum pitch width for the slots provided between successive cards such that the pitch is wide enough for the connector to be easily installed in place; or it may cause a reduction in the maximum available depth of the shelf because of the need to provide sufficient routing space for the front area cabling.

It is therefore desired to provide a connection arrangement for a front access shelf which would avoid or substantially overcome the above drawbacks associated with the known connection arrangements.

### DESCRIPTION OF THE INVENTION

The above objective is achieved by using the solution proposed by the present invention according to which separate planes are determined for the internal connections and the I/O signals connections.

Accordingly, one object of the present invention is that of providing a connection arrangement for a shelf, the shelf having a three-dimensional structure with a front side, a rear side, a top side and a bottom side, providing a housing for receiving a replaceable card comprising electronic circuitry wherein said card is capable of being inserted in or extracted from the shelf through a front plane located at the front side thereof, the shelf further comprising a back-plane for providing access to internal electrical connections inside the shelf located at the rear side thereof, characterized in that the shelf further comprises a further plane of access for connection of input and/or output signals to and from the shelf respectively, such that said further plane of access is in a position which is different from the front side and the rear side of the shelf.

According to an aspect of the present invention, said further plane of access is disposed in a perpendicular position with respect to the rear side of the shelf.

According to another aspect of the invention the further plane of access is provided at the top side or the bottom side or a lateral side of the shelf. The choice of the position of the plane of access is made in accordance to design requirements.

These and further features of the present invention are explained in more detail in the following description as well as in the claims with the aid of the accompanying drawings.

### BRIEF DESCRIPTION OF THE DRAWINGS

Figures 1 a, 1b and 1 c show simplified schematic representations of three configurations for connection arrangements in shelves according to known solutions.
Figure 2 is a simplified schematic representation of a shelf having a connection arrangement according to the present invention.

### EXAMPLES OF PREFERRED EMBODIMENTS

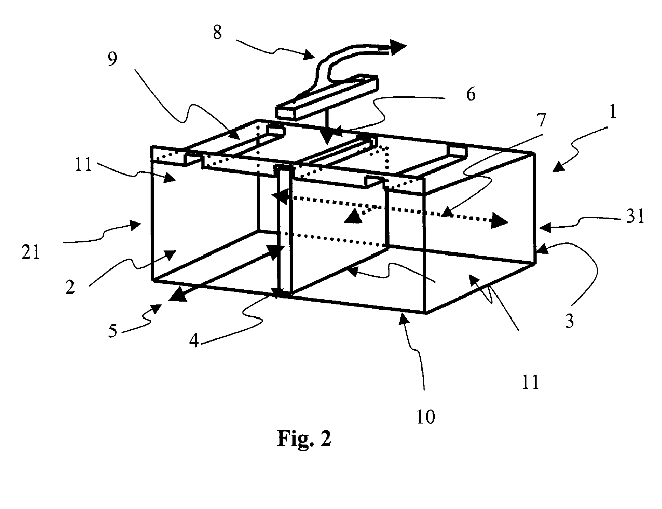

Figure 2 shows one example of application of the solution of the present invention in a shelf in which electronic cards are inserted in vertical position through the front plane. In this example, the back-plane is used for the internal signals routing and interconnection.

Referring to figure 2, there is shown a shelf 1, having a front-plane 2 located at the front side 21 of the shelf and a back-plane 3 located at the rear side 31 of the shelf. A replaceable electronic card 4 is shown inserted in a vertical position inside the shelf 1. It is clearly understood that card 4 may be extracted from the front plane 2 of the shelf by moving the card outwards.

The insertion and extraction of the card are represented in figure 2 by means of arrow 5.

The internal connections between components inside the shelf 1 are routed by means of access provided through the back-plane 3 as shown by the set of arrows 7. The plane of access for the internal connections may thus be considered as the plane defined by the rear side 31 of the shelf.

According to the invention, the I/O signal connection from external equipment is provided through access from a side of the shelf which is different from the front side 21 or the rear side 31 thereof. In the figure, access is provided at the top side wherein a connector 8 is shown in a position suitable for being moved downwards in the directions shown by arrow 6 and engaged to connector terminals located at the corresponding side of the card 4 where the connector 8 is finally engaged.

Therefore, in the example of figure 2, the plane of access of the I/O signals is the top side 9 of the shelf which is perpendicular to the plane of access to the internal connections inside the shelf, which is the rear side 31.

In this manner, the routing of I/O signals is separated from the routing of the internal connections, thus avoiding complicated layering as compared to the type A arrangements of the known solutions. Also, the access to the front plane in order to insert or extract the card is kept clear and easily handled. Furthermore no additional empty space is required at the front or the rear side of the shelf as compared to the aforementioned type B arrangements of the prior art solutions. Other important advantages of the present solution are in relation to cost saving due to the use of less layers in the back-plane, less connectors in the cards, and avoiding double set of connectors in the back-plane as would be required in the conventional solutions. Furthermore, the present invention provides the possibility of achieving a relatively larger depth of the shelf as compared to the known solution type C, and thus optimizing the effective area for the electronic card.

The present invention further allows for increasing the I/O signaling capability of the cards using the same type of back-plane as used in the known solutions.

It is to be noted that the embodiment of figure 2 is only one example among other possible configurations falling within the scope of the present invention. For example, while in figure 2 the I/O connections are provided at the top side of the shelf, it is equally possible to provide such access at the bottom side or any of the lateral sides thereof. Another possible configuration is that the card is inserted in or extracted from the shelf horizontally in which case the I/O connection could be accessed though a lateral side 11 of the shelf.

The configuration of the connections according the example of figure 2 of present invention may be summarized as shown in the table below:

| Type | Cards Access insertion/extraction | Internal signals interconnection | I/O signals location | I/O Access |
|---|---|---|---|---|
| D | Front plane | Back-plane at rear side | Top or Bottom edge of cards | Top or Bottom plane |

## Claims

1. A connection arrangement for a shelf (1), the shelf (1) having a three-dimensional structure with a front side (21), a rear side (31), a top side (9) and a bottom side (10), providing a housing for receiving a replaceable card (4) comprising electronic circuitry wherein said card is capable of being inserted in or extracted from the shelf (1) through a front plane (2) located at the front side (21) thereof, the shelf further comprising a back-plane (3) for providing access to internal electrical connections inside the shelf (1) located at the rear side thereof (31), **characterized in that** the shelf further comprises a further plane of access (9, 10) for connection of input and/or output signals to and from the shelf (1) respectively, such that said further plane of access (9, 10) is in a position which is different from the front side (21) and the rear side (31) of the shelf (1).

2. A connection arrangement according to claim 1, wherein said further plane of access (9, 10) is disposed in a perpendicular position with respect to the rear side of the shelf.

3. A connection arrangement according to claim 1 or 2, wherein said further plane of access (9, 10) is provided at the top side (9), the bottom side (10) or a lateral side (11) of the shelf.

4. A shelf adapted for having a connection arrangement according to any one of claims 1 to 3.

5. An electronic card for use in the connection arrangement according to any one of claims 1 to 3 or for use in a shelf according to claim 4.
